(19) Europäisches Patentamt
European Patent Office
Office européen des brevets

(11) **EP 1 516 468 B1**

(12) **EUROPÄISCHE PATENTSCHRIFT**

(45) Veröffentlichungstag und Bekanntmachung des Hinweises auf die Patenterteilung:
**11.08.2010  Patentblatt 2010/32**

(21) Anmeldenummer: **03761437.7**

(22) Anmeldetag: **26.06.2003**

(51) Int Cl.:
*H04L 27/06* (2006.01)    *H03D 1/22* (2006.01)
*H03D 7/16* (2006.01)    *H04B 1/30* (2006.01)

(86) Internationale Anmeldenummer:
**PCT/DE2003/002137**

(87) Internationale Veröffentlichungsnummer:
**WO 2004/004266 (08.01.2004 Gazette 2004/02)**

(54) **EMPFÄNGERANORDNUNG, INSBESONDERE FÜR DEN MOBILFUNK**

RECEIVER DEVICE, ESPECIALLY FOR MOBILE RADIO

ENSEMBLE DE RECEPTION, NOTAMMENT POUR LA RADIOTELEPHONIE MOBILE

(84) Benannte Vertragsstaaten:
**DE FR GB IT**

(30) Priorität: **27.06.2002   DE 10228757**

(43) Veröffentlichungstag der Anmeldung:
**23.03.2005   Patentblatt 2005/12**

(73) Patentinhaber: **Infineon Technologies AG
85579 Neubiberg (DE)**

(72) Erfinder:
• **HAMMES, Markus
46539 Dinslaken (DE)**
• **VAN WAASEN, Stefan
19248 - Sollentuna (SE)**

(74) Vertreter: **Viering, Jentschura & Partner
Postfach 22 14 43
80504 München (DE)**

(56) Entgegenhaltungen:
**DE-A- 19 536 526     US-A- 5 878 089**

## Beschreibung

Die vorliegende Erfindung betrifft eine Empfängeranordnung, insbesondere für den Mobilfunk.

Normalerweise sind moderne, digitale Mobilfunksysteme ausschließlich vollduplexfähige Systeme. Vollduplex-Systeme zeichnen sich dadurch aus, daß gleichzeitig gesendet und empfangen werden kann. Dabei wird auch dann von vollduplexfähigen Systemen gesprochen, wenn Senden und Empfangen nicht gleichzeitig erfolgen, das Umschalten zwischen den Übertragungsrichtungen aber vom Teilnehmer unbemerkt erfolgt.

Grundsätzlich werden zwei Duplex-Verfahren unterschieden. Bei dem sogenannten Frequenzduplex (FDD, Frequency Division Duplex) erfolgen Senden und Empfangen in verschiedenen, dedizierten Frequenzbändern. Beim Zeitduplex (TDD, Time Division Duplex) hingegen werden die Übertragungsrichtungen in verschiedenen Zeitlagen oder Zeitschlitzen getrennt.

Bei dem weit verbreiteten Mobilfunkstandard GSM, Global System for Mobile Communication, werden TDD- und FDD-Verfahren gemischt eingesetzt, um möglichst kostengünstig herstellbare und gut integrierbare Transceiver bereitstellen zu können.

Insbesondere im Empfangsteil von modernen Mobilfunksystemen kommt anstelle der homodynen Empfängerarchitektur (Direct Conversion) aufgrund der dabei auftretenden Offset-Problematik zunehmend die sogenannte Low-IF-Empfängerarchitektur zum Einsatz. Dabei wird das empfangene Hochfrequenzsignal zunächst auf eine verhältnismäßig geringe Zwischenfrequenz (englisch: Intermediate Frequency, IF) und in einem zweiten Schritt ins Basisband heruntergemischt.

Bei derart ausgebildeten Sendeempfängern, zwischen denen eine Zweipunktverbindung vorgesehen ist, ergibt sich regelmäßig die Problematik, daß bedingt durch die von Null verschiedene Zwischenfrequenz zwischen Sende- und Empfangszeitschlitzen stets ein Kanalwechsel stattfinden muß. Das heißt, daß die Phasenregelschleife des Sendeempfängers zwischen Sende- und Empfangszeitschlitzen stets auf eine neue Frequenz einschwingen muß, auch dann, wenn der nominelle Kanal eigentlich nicht gewechselt werden soll. Dies führt jedoch nachteilhafterweise dazu, daß die Netto-Datenübertragungsrate, welche über den Übertragungskanal erzielt wird, bezüglich der Bruttodatenrate stark reduziert wird.

In dem Dokument DE 100 46 586 sind Systeme zur Datenübertragung angegeben, die dieses Problem durch die Einstellung des Empfangsseitenbandes des Low-IF-Receivers, die sogenannte Sideband Selection, lösen. Dabei ist vorgesehen, daß bei einer Zweipunktverbindung einer der beiden Empfänger ein empfangenes hochfrequentes Signal in ein komplexwertiges Zwischenfrequenzsignal mit positiver Zwischenfrequenz und der andere Empfänger in ein IQ-Signal mit negativer Zwischenfrequenz heruntermischt. Dieses Vorgehen erlaubt es, daß die Phasenregelschleife nicht zwischen jedem Sende- und Empfangszeitschlitz auf eine neue Trägerfrequenz einschwingen muß und daß daher mit Vorteil eine Phasenregelschleife, PLL mit langsamer Einschwingzeit verwendet werden kann.

Alternativ zu der Verwendung positiver oder negativer Zwischenfrequenzebenen kann auch eine Empfängerstruktur mit spiegelfrequenzunterdrückendem Mischer in beiden Funkteilen der Zweipunktverbindung verwendet werden.

Als Nachteil derartiger Empfängerstrukturen bleibt jedoch, daß die Empfänger bezüglich der zweiten Abwärtsmischstufe, die von der Zwischenfrequenz ins Basisband heruntermischt, sowohl für eine Lage der Kanalfrequenz unterhalb, als auch für eine Lage der Kanalfrequenz oberhalb der Lokaloszillatorfrequenz der zweiten Mischstufe ausgelegt werden müssen.

Eine zumindest theoretische Möglichkeit zur Lösung dieser Problematik besteht darin, die entsprechenden analogen und digitalen Bauteile doppelt auszulegen für die beiden regelmäßig auftretenden beschriebenen Fälle. Dies bedeutet selbstverständlich einen erheblichen Mehraufwand.

Aufgabe der vorliegenden Erfindung ist es, eine Empfängeranordnung, insbesondere für den Mobilfunk, anzugeben, welche für Mobilfunkverfahren mit Zeitduplex-Komponente geeignet ist, die Verwendung von Phasenregelschleifen mit langsamer Einschwingzeit erlaubt und dabei mit geringem Aufwand realisierbar ist.

In dem Dokument DE 195 36 526 A ist eine Empfängerarchitektur zum Empfangen von winkelmodulierten/-getasteten Trägersignalen unterschiedlicher Frequenz angegeben. Diese umfasst eine Mischeranordnung, die komplexwertige Signale verarbeitet.

Das Dokument US 5,878,089 zeigt einen kohärenten Signaldetektor für die Rückgewinnung von AM-kompatiblen Digital Audio Broadcast Signalen. Diese können als komplexe, in Inphase- und Quadraturkomponente zerlegte Signale vorliegen. Es ist ein digitaler Quadratur-Abwärtskonverter vorgesehen.

Erfindungsgemäß wird die Aufgabe gelöst durch eine Empfängeranordnung, insbesondere für den Mobilfunk, aufweisend

- einen Abwärts-Frequenzmischer, ausgelegt zur Multiplikation komplexwertiger Signale, mit einem ersten Eingang umfassend einen Inphase- und einen Quadraturanschluß, mit einem zweiten Eingang umfassend einen Inphase- und einen Quadraturanschluß und mit einem Ausgang umfassend einen Inphase- und einen Quadraturanschluß, und
- eine Einrichtung zum Umschalten von Inphase- und Quadraturanschluß in Abhängigkeit von einem Steuersignal,

in Abhängigkeit davon, ob das Nutzsignal im oberen oder unteren Empfangsseitenband liegt, die einen Inphase- und einen Quadratür-Eingang sowie einen Inphase- und einen Quadratur-Ausgang hat; die an den Inphase- bzw. Quadraturanschluss des ersten oder zweiten Eingangs des Abwärts-Frequenzmischers angeschlossen sind, mit einem ersten Schaltzustand, in dem der Inphase-Eingang mit dem Inphase-Ausgang und der Quadratur-Eingang mit dem Quadratur-Ausgang verbunden ist, und mit einem zweiten Schaltzustand, in dem der Inphase-Eingang mit dem Quadratur-Ausgang und der Quadratur-Eingang mit dem Inphase-Ausgang verbunden ist.

Gemäß dem vorliegenden Prinzip ist eine komplexwertige Signalverarbeitung des empfangenen Nutzsignals vorgesehen. In Abhängigkeit davon, ob das Nutzsignal im oberen oder unteren Empfangsseitenband liegt, wird gemäß vorliegendem Prinzip Inphase- und Quadraturkomponente des komplexwertigen Signals vertauscht oder nicht. Dabei kann die Vertauschung entweder bezüglich des komplexwertig vorliegenden Nutzsignals selbst oder bezüglich des dem Mischer ebenfalls zuzuführenden Lokaloszillatorsignals erfolgen.

Diese Möglichkeit, Inphase- und Quadraturkomponente des komplexwertigen Signals am Mischereingang zu vertauschen, ermöglicht eine Weiterverarbeitung des Signals unabhängig davon, ob das obere oder das untere Seitenband moduliert war. Gemäß dem vorliegenden Prinzip kann mit Vorteil die Lokaloszillatorfrequenz zwischen Senden und Empfangen unverändert bleiben, wobei es dennoch möglich ist, den oberhalb der Lokaloszillatorfrequenz liegenden oder den unterhalb der Lokaloszillatorfrequenz liegenden Kanal, je nach moduliertem Seitenband, herunterzumischen.

Das beschriebene Prinzip ist weiterhin mit geringem Aufwand realisierbar, da lediglich zwei bzw. vier Multiplexer zusätzlich vorzusehen sind. Gemäß vorliegendem Prinzip werden keine zusätzlichen Bauteile zur Inversion der nachfolgenden Demodulation oder zur Phasenverschiebung der Signals benötigt. Außerdem muß der Abwärtsfrequenzmischer nicht seine Drehrichtung ändern.

In Abhängigkeit davon, ob das Lokaloszillatorsignal oder das Nutzsignal selbst bezüglich I- und Q-Signalkomponente umgeschaltet beziehungsweise vertauscht wird, kann am erzeugten Ausgangssignal des Abwärtsfrequenzmischers noch eine Phasenverschiebung von 90 Grad gegenüber dem eigentlich gewünschten Signal und/oder ein inverses Vorzeichen des erzeugten Signals vorliegen. Dies hat jedoch keine nachteilhaften Auswirkungen auf die weitere Signalverarbeitung im Empfänger.

Gemäß einer bevorzugten Weiterbildung der Erfindung umfaßt die Einrichtung zum Vertauschen von Inphase- und Quadraturanschluß einen ersten Multiplexer und einen zweiten Multiplexer. Die Ausgänge der beiden Multiplexer sind mit Inphase- und Quadraturanschluß von erstem oder zweitem Eingang des Abwärts-Frequenzmischers verbunden.

Demnach bewirkt die Einrichtung zum Vertauschen von Inphase- und Quadraturanschluß mit den beiden Multiplexern entweder eine Vertauschung von Inphase- und Quadraturkomponente des Nutzsignals oder des Lokaloszillatorsignals am Eingang des Abwärts-Frequenzmischers.

Die beiden Multiplexer haben bevorzugt jeweils einen ersten und einen zweiten Eingang, die derart miteinander verbunden sind, daß an den Ausgängen der Multiplexer in Abhängigkeit von einem Steuersignal das komplexwertige, in Inphase- und Quadraturkomponente zerlegte Signal entweder unverändert oder mit vertauschten Komponenten bereitgestellt wird. Dabei sind die Steuereingänge bevorzugt miteinander zum Zuführen des Umschalt-Steuersignals verbunden. Das Steuersignal wird in Abhängigkeit davon bereitgestellt, ob das eingangsseitige Nutzsignal des Abwärts-Frequenzmischers bezüglich seines oberen oder seines unteren Seitenbandes moduliert ist.

Die Empfängeranordnung hat bevorzugt eine heterodyne Struktur, beispielsweise eine Low-IF-Empfängerstruktur. Dabei ist neben dem bereits erwähnten Abwärts-Frequenzmischer, der in diesem Fall ein Zwischenfrequenzsignal ins Basisband heruntermischt, eingangsseitig ein weiterer Abwärts-Frequenzmischer vorgeschaltet, welcher ein Hochfrequenzsignal in ein komplexwertiges Zwischenfrequenzsignal umsetzt. Den beiden Abwärts-Frequenzmischern wird bevorzugt jeweils ein geeignetes Lokaloszillatorsignal zugeführt, welches beispielsweise von einer jeweiligen Phasenregelschleife erzeugt werden kann. Bei einer derartigen heterodynen Empfängerstruktur ist die Einrichtung zum Umschalten von Inphase- und Quadraturanschluß demnach entweder in den komplexwertigen Nutzsignalpfad zwischen die beiden Abwärts-Frequenzmischer geschaltet oder zwischen den Frequenzgenerator, der das Lokaloszillatorsignal erzeugt, und denjenigen Abwärts-Frequenzmischer geschaltet, der die Umsetzung von der Zwischenfrequenzebene ins Basisband bewirkt.

In dem Falle, daß die Einrichtung zum Vertauschen von Inphase- und Quadraturanschluß zwischen beide Abwärts-Frequenzmischer geschaltet ist, ist mit Vorteil eine weitere Einrichtung zum Vertauschen von Inphase- und Quadraturpfad an den Ausgang des Abwärts-Frequenzmischers geschaltet, der von der Zwischenfrequenz ins Basisband umsetzt. Dies hat den Vorteil, daß ein durch Vertauschen der Komponenten des Nutzsignals bedingtes Vorzeichen wieder kompensiert wird.

Ausgangsseitig an den Abwärts-Frequenzmischer, der in der allgemeinen Form der Erfindung vorgesehen ist, ist bevorzugt ein Demodulator angeschlossen, der das von der Zwischenfrequenzebene ins Basisband heruntergemischte Signal demoduliert. Dieser Demodulator ist bevorzugt als Quadri-Korrelator oder als Verzögerungs-Demodulator ausgebildet, je nachdem, ob die weitere Signalverarbeitung in analoger oder digitaler Form erfolgt.

Weitere Einzelheiten und vorteilhafte Ausgestaltungen der Erfindung ergeben sich aus den Unteransprüchen.

Die Erfindung wird nachfolgend an mehreren Ausführungsbeispielen anhand der Figuren näher erläutert.

Es zeigen:

Figur 1    ein erstes Ausführungsbeispiel des erfindungsgemä- ßen Prinzips anhand eines vereinfachten Block- schaltbildes und

Figur 2    ein weiteres Ausführungsbeispiel des vorliegenden Prinzips anhand eines vereinfachten Blockschaltbil- des.

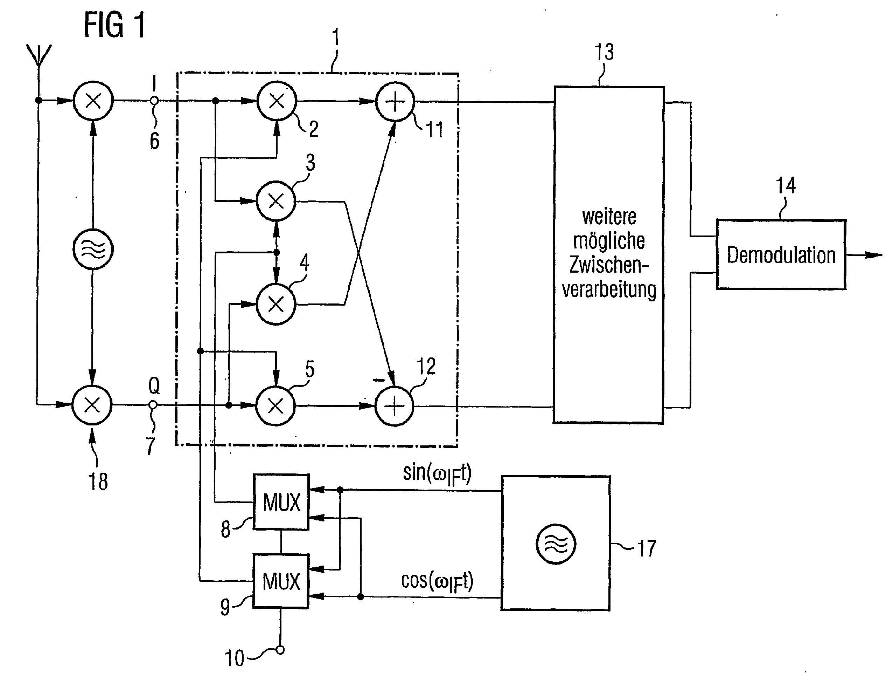

Figur 1 zeigt eine Empfängeranordnung mit einem Abwärts-Frequenzmischer 1, der ausgelegt ist zum Heruntermischen eines Nutzsignals, welches als komplexwertiges Signal vorliegt, von einer Zwischenfrequenzebene ins Basisband. Das komplexwertige Signal ist dabei ein in eine Inphase-Komponente und eine dazu orthogonal stehende Quadratur-Komponente zerlegtes Signal. Derartige, zur komplexwertigen Signalverarbeitung ausgelegte Frequenzmischer 1 werden auch als IQ-Mischer bezeichnet. Der vorliegende Abwärts-Frequenzmischer 1 umfaßt vier Mischerzellen 2 bis 5, welche jeweils zwei Eingänge und einen Ausgang haben, an dem ein multipliziertes Signal bereitgestellt wird. Der erste Eingang der ersten Mischerzelle 2 ist mit dem Inphase-Eingang 6 des Frequenzmischers 1 verbunden, ebenso wie der erste Eingang der zweiten Mischerzelle 3. Die ersten Eingänge der dritten und vierten Mischerzelle 4, 5 sind mit dem Quadratur-Eingang 7 des Abwärts-Frequenzmischers 1 verbunden. Den zweiten Eingängen der Mischerzellen 2 bis 5 wird ein Lokaloszillatorsignal mit der Trägerfrequenz des an den Eingängen 6, 7 anliegenden Nutzsignals I, Q zugeführt. Dabei ist jedoch eine Einrichtung zum Vertauschen von Inphase- und Quadraturkomponente des Lokaloszillatorsignals 8, 9 vorgesehen, die zwischen einen Frequenzgenerator 17 und die zweiten Eingänge des Mischers 1 geschaltet ist. Diese Einrichtung 8, 9 umfaßt einen ersten Multiplexer 8 und einen zweiten Multiplexer 9. Die Multiplexer 8, 9 haben jeweils zwei Eingänge und einen Ausgang sowie einen Steuereingang 10 zum Zuführen eines Umschaltbefehls. Der Ausgang des Multiplexers 8 ist mit den zweiten Eingängen der Mischerzellen 3, 4 verbunden. Der Ausgang des zweiten Multiplexers 9 ist mit den zweiten Eingängen von erster und vierter Mischerzelle 2, 5 verbunden. Die ersten und die zweiten Eingänge der beiden Multiplexer 8, 9 sind jeweils miteinander zur Bildung eines Lökaloszillatoreingangs zur Zuführung eines Lokaloszillatorsignals mit um 90 Grad zueinander stehenden Signalkomponenten verbunden. An den so gebildeten 0°/90°-Lokaloszillatoreingang ist ein Frequenzgenerator 17, ausgeführt als Phasenregelkreis mit Signalaufbereitung angeschlossen. Der Abwärts-Frequenzmischer 1 umfaßt neben den Mischerzellen 2 bis 5 zwei Summierknoten 11, 12, welche je zwei Eingänge und einen Ausgang haben. Die Eingänge des Summierknotens 11 sind mit den Ausgängen der Mischerzellen 2 und 4 verbunden, wobei der Ausgang der Mischerzelle 4 invertierend angeschlossen ist. Die Ausgänge der Mischerzellen 3, 5 sind mit den Eingängen des Summierknotens 12 verbunden. Die Ausgänge der Summierknoten 11, 12 bilden die IQ-Ausgänge des Abwärts-Frequenzmischers 1 und sind an eine weitere Signalverarbeitungsstufe 13 angeschlossen, an deren Ausgang wiederum ein Demodulator 14 angeschlossen ist. Bis zum Demodulator 14 wird das zu demodulierende Signal als komplexwertiges Signal geführt.

An den IQ-Eingang 6, 7 ist eine weitere Abwärts-Frequenzmischstufe 18 angeschlossen, die ein von einer Antenne empfangenes Hochfrequenzsignal in eine Zwischenfrequenzebene umsetzt. In der Zwischenfrequenzebene sind zwischen Mischstufe 18 und Mischstufe 1 noch weitere Signalaufbereitungsmittel, wie Verstärker und Filter vorgesehen, die jedoch vorliegend nicht eingezeichnet sind, da sie für das Verständnis des erfindungsgemäßen Prinzips nicht notwendig sind.

In Abhängigkeit davon, welches Seitenband des Nutzsignals moduliert ist, ist es mit dem vorliegenden Prinzip möglich, durch Vertauschen der Inphase- und Quadraturkomponente des Lokaloszillatorsignals die lokale Oszillatorfrequenz unverändert zu lassen und dennoch einmal den oberhalb und einmal den unterhalb der Lokaloszillatorfrequenz liegenden Kanal herunterzumischen. Dies soll nachfolgend anhand einer mathematischen, beispielhaften Beschreibung mit einem komplexwertigen Signal $s(t) = I(t) + jQ(t)$ erläutert werden:

$$s_{LO} = \exp(-j\,\omega_{IF}\,t),$$

$$s_{+IF} = \exp(j\,[\omega_{IF}\,t + \phi(t)]),$$

$$s_{-IF} = \exp(j\,[-\omega_{IF}\,t + \phi(t)]),$$

$$s_{+IF} * s_{LO} = \exp(j\ [\omega_{IF}\ t\ +\ \phi(t)\ -\ \omega_{IF}\ t]) = \exp(j\ \phi(t)),$$

$$s_{-IF} * s_{LO,I<->Q} = j * \exp(j\ [-\omega_{IF}\ t\ +\ \phi(t)]\ +\ j\ \omega_{IF}\ t])$$
$$= j * \exp(j\ \phi(t)).$$

mit $s_{LO}$ gleich Lokaloszillator-Signal, $s_{LO,I<->Q}$ gleich Lokaloszillator-Signal mit vertauschten Quadraturkomponenten, $s_{+IF}$ und $s_{-IF}$ gleich IF-Signal mit moduliertem oberem bzw. unterem Seitenband, $\omega_{IF}$ gleich Kreisfrequenz des Zwischenfrequenz-Signals.

Somit kann mit Vorteil auf eine doppelte Auslegung analoger und digitaler Komponenten für die Fälle, daß oberes oder unteres Seitenband moduliert ist, verzichtet werden. Als weiterer Vorteil kann eine Phasenregelschleife als Frequenzgenerator 17 eingesetzt werden, die zwischen Sende- und Empfangszeitschlitzen nicht ihre Frequenz ändern braucht, wenn der nominelle Kanal gleich bleibt.

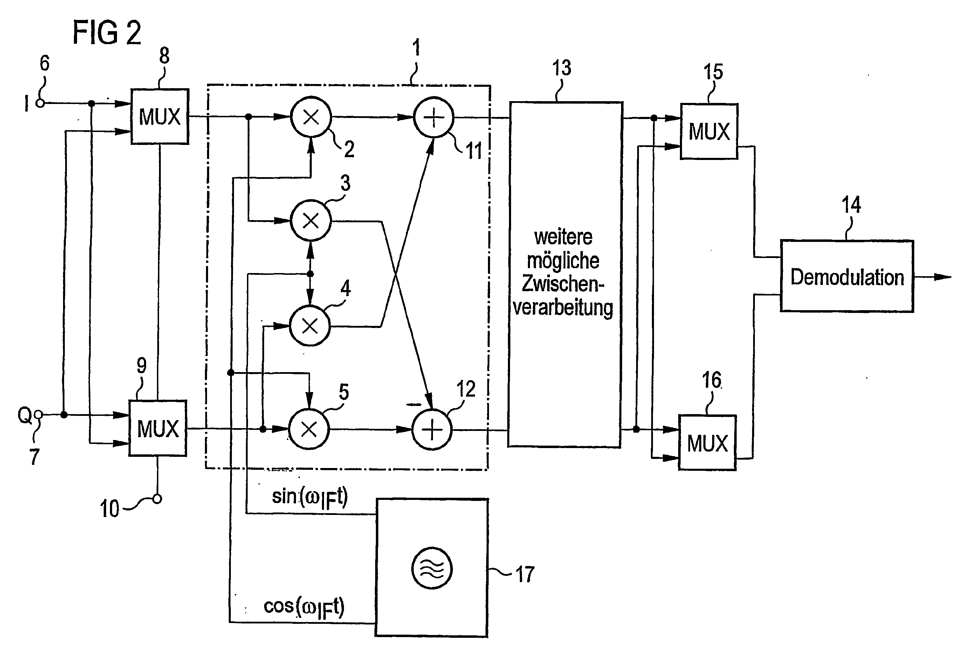

Wie bereits erwähnt, kann das Multiplexen, welches ein Vertauschen von Inphase- und Quadraturkomponente bewirkt, alternativ auch im Nutzsignal anstelle des LO-Signals vorgesehen sein. Ein derartiges Ausführungsbeispiel ist in Figur 2 gezeigt.

Figur 2 zeigt ein Blockschaltbild einer alternativen Ausführungsform der Erfindung anhand eines beispielhaften Blockschaltbildes, welches in verwendeten Bauteilen, vorteilhafter Verschaltung und Funktionsweise weitgehend demjenigen von Figur 1 entspricht. Insoweit wird die Beschreibung an dieser Stelle nicht noch einmal wiederholt. Lediglich die Anordnung der Multiplexer 8, 9 ist bei der Darstellung von Figur 2 nicht in der Zuführung des Lokaloszillatorsignals und demnach den zweiten Eingängen der Mischerzellen 2 bis 5 vorgeschaltet vorgesehen, sondern vielmehr an den ersten Eingängen der Mischerzellen 2 bis 5 und demnach im Nutzsignalpfad. Außerdem ist zur Kompensation eines auftretenden negativen Vorzeichens im Nutzsignal eine weitere Einrichtung zum Vertauschen von Inphase- und Quadraturanschluß vorgesehen, welche mit Bezugszeichen 15, 16 versehen und in I- und Q-Pfad zwischen die Verarbeitungseinheit 16 und den Demodulator 14 geschaltet ist.

Im Einzelnen ist der Inphase-Eingang 6 des Abwärts-Mischstufe mit dem ersten Eingang des ersten Multiplexers 8 und dem zweiten Eingang des zweiten Multiplexers 9 verbunden. Der Quadratur-Eingang 7 ist mit dem zweiten Eingang des ersten Multiplexers 8 und dem ersten Eingang des zweiten Multiplexers 9 verbunden. Die Steuereingänge der beiden Multiplexer 8, 9 sind wiederum miteinander und einem Umschalteingang 10 verbunden zum Umschalten zwischen erstem und zweitem Schaltzustand der Umschalteinrichtung 8, 9. Der Ausgang des Multiplexers 8 ist mit den ersten Eingängen von erster und zweiter Mischerzelle 2, 3 verbunden, während der Ausgang des zweiten Multiplexers 9 mit den ersten Eingängen von dritter und vierter Mischerzelle 4, 5 verbunden ist. Eine Komponente des Lokaloszillatorsignals wird den zweiten Eingängen von erster und vierter Mischerzelle 2, 5 zugeführt, während die andere, dazu orthogonal stehende Komponente des komplexwertigen Lokaloszillatorsignals der zweiten und dritten Mischerzelle 3, 4 zugeführt wird. Hierfür sind die zweiten Eingänge der Mischerzellen 2 bis 5 mit dem 0Grad/90Grad-Ausgang des Frequenzgenerators 17 verbunden. Der Aufbau des Abwärts-Frequenzmischers 1 ist bezüglich des Schaltbildes von Figur 1 unverändert. Die weitere Einrichtung zur Vertauschung von Inphase- und Quadraturanschluß umfaßt zwei Multiplexer 15, 16, mit je zwei Eingängen und einem Ausgang. Diese sind, ebenso wie die Multiplexer 8, 9 von Figur 2, so verschaltet, daß je nach Steuersignal Inphase- und Quadraturkomponente am Ausgang der Zwischenverarbeitungsstufe 13 dem Demodulator 14 entweder unverändert oder vertauscht zugeführt werden.

Dies ermöglicht eine vorzeichenrichtige Behandlung des Modulationssignals durch nochmaliges Vertauschen von I- und Q-Pfad.

Die Funktionsweise der Schaltung nach Figur 2 wird ebenfalls anhand einer mathematischen Beschreibung in Anlehnung an das Beispiel von Figur 1 erläutert:

$$s_{-IF,I<->Q} * s_{LO} = j * \exp(-j\ [-\omega_{IF}\ t\ +\ \phi(t)]\ -\ j\ \omega_{IF}\ t)$$
$$= j * \exp(-j\ \phi(t)),$$

dabei repräsentiert $s_{-IF,I<->Q}$ das Nutzsignal mit vertauschten Quadraturkomponenten.

Man erkennt, daß ebenso wie bei Figur 1 die am Ausgang der Schaltung abgreifbaren Signale eine Phasenverschiebung von 90 Grad gegenüber dem gewünschten Signal haben, was jedoch keine nachteilhaften Einflüsse auf die weitere Signalverarbeitung ausübt.

Die Vorteile der Schaltung von Figur 2 entsprechen denen des Ausführungsbeispiels von Figur 1 und werden daher hier nicht noch einmal aufgeführt.

Es liegt selbstverständlich im Rahmen der Erfindung, auch andere Schaltungsmittel einzusetzen, um die dem erfindungsgemäßen Prinzip zugrundeliegende Vertauschung von Inphase- und Quadraturkomponente in Abhängigkeit von einem Steuersignal zu erzielen.

Bezugszeichenliste

| | |
|---|---|
| 1 | Abwärts-Frequenzmischer |
| 2 | Mischerzelle |
| 3 | Mischerzelle |
| 4 | Mischerzelle |
| 5 | Mischerzelle |
| 6 | Inphase-Eingang |
| 7 | Quadratur-Eingang |
| 8 | Multiplexer |
| 9 | Multiplexer |
| 10 | Steuereingang |
| 11 | Summierknoten |
| 12 | Summierknoten |
| 13 | Zwischenverarbeitung |
| 14 | Demodulator |
| 15 | Multiplexer |
| 16 | Multiplexer |
| 17 | LO-Frequenzgenerator |
| 18 | Abwärts-Frequenzmischer |

**Patentansprüche**

1. Empfängeranordnung, insbesondere für den Mobilfunk, aufweisend

- einen Abwärts-Frequenzmischer (1), ausgelegt zur Multiplikation komplexwertiger Signale, mit einem ersten Eingang umfassend einen Inphase- und einen Quadraturanschluß, mit einem zweiten Eingang umfassend einen Inphase- und einen Quadraturanschluß und mit einem Ausgang umfassend einen Inphase- und einen Quadraturanschluß, und
- eine Einrichtung zum Umschalten von Inphase- und Quadraturanschluß (8, 9) in Abhängigkeit von einem Steuersignal in Abhängigkeit davon, ob das Nutzsignal im oberen oder unteren Empfangsseitenband liegt, die einen Inphase- und einen Quadratur-Eingang sowie einen Inphase- und einen Quadratur-Ausgang hat, die an den Inphase- bzw. Quadraturanschluss des ersten oder zweiten Eingangs des Abwärts-Frequenzmischers (1) angeschlossen sind, mit einem ersten Schaltzustand, in dem der Inphase-Eingang mit dem Inphase-Ausgang und der Quadratur-Eingang mit dem Quadratur-Ausgang verbunden ist, und mit einem zweiten Schaltzustand, in dem der Inphase-Eingang mit dem Quadratur-Ausgang und der Quadratur-Eingang mit dem Inphase-Ausgang verbunden ist.

2. Empfängeranordnung nach Anspruch 1,
**dadurch gekennzeichnet, daß**
die Einrichtung zum Umschalten von Inphase- und Quadraturanschluß einen ersten Multiplexer (8) umfaßt, dessen Ausgang mit dem Inphase-Anschluß verbunden ist und einen zweiten Multiplexer (9), dessen Ausgang mit dem Quadratur-Anschluß von erstem beziehungsweise zweitem Eingang des Abwärts-Frequenzmischers verbunden ist.

3. Empfängeranordnung nach Anspruch 2,
**dadurch gekennzeichnet, daß**
der erste Multiplexer (8) und der zweite Multiplexer (9) je einen Steuereingang zum Umschalten zwischen erstem und zweitem Schaltzustand haben, wobei die beiden Steuereingänge miteinander zum Zuführen des Steuersignals verbunden sind.

**4.** Empfängeranordnung nach einem der Ansprüche 1 bis 3,
**dadurch gekennzeichnet, daß**
ein Frequenzgenerator (17) ausgebildet zum Erzeugen eines Lokaloszillator-Signals vorgesehen ist, mit einem Ausgang umfassend einen Inphase- und einen Quadraturanschluß, der mit dem zweiten Eingang des Abwärts-Frequenzmischers (1) gekoppelt ist.

**5.** Empfängeranordnung nach einem der Ansprüche 1 bis 4,
**dadurch gekennzeichnet, daß**
der Empfänger als Heterodynempfänger ausgebildet ist, mit einem weiteren Abwärts-Frequenzmischer (18), der mit seinem Ausgang mit dem ersten Eingang des Abwärts-Frequenzmischers (1) gekoppelt ist.

**6.** Empfängeranordnung nach Anspruch 4,
**dadurch gekennzeichnet, daß**
die Einrichtung zum Umschalten von Inphase- und Quadraturanschluß (8, 9) zwischen den Ausgang des Frequenzgenerators (17) und den zweiten Eingang des Abwärts-Frequenzmischers (1) geschaltet ist.

**7.** Empfängeranordnung nach Anspruch 5,
**dadurch gekennzeichnet, daß**
die Einrichtung zum Umschalten von Inphase- und Quadraturanschluß (8, 9) zwischen den Ausgang des weiteren Abwärts-Frequenzmischers (18) und den ersten Eingang des Abwärts-Frequenzmischers (1) geschaltet ist.

**8.** Empfängeranordnung nach Anspruch 7,
**dadurch gekennzeichnet, daß**
eine weitere Einrichtung zum Umschalten von Inphase- und Quadraturanschluß (15, 16) an den Ausgang des Abwärts-Frequenzmischers (1) angekoppelt ist.

**9.** Empfängeranordnung nach einem der Ansprüche 1 bis 8,
**dadurch gekennzeichnet, daß**
dem Abwärts-Frequenzmischer (1) ein als Quadri-Korrelator ausgeführter Demodulator (14) nachgeschaltet ist.

**Claims**

**1.** Receiver device, especially for mobile radio, comprising

- a step-down controller (1), configured for multiplication of complex-valued signals, having a first input comprising an in-phase and a quadrature terminal, having a second input comprising an in-phase and a quadrature terminal and having an output comprising an in-phase and a quadrature terminal, and
- a device for switching over the in-phase and quadrature terminal (8, 9) depending on a control signal depending on whether the useful signal is located in the upper or in the lower reception side band, having an in-phase and a quadrature input as well as an in-phase and a quadrature output, which are connected to the in-phase and quadrature terminal of the first or the second input of the step-down controller (1), respectively, having a first switching state, wherein the in-phase input is connected to the in-phase output and the quadrature input is connected to the quadrature output, and having a second switching state, in which the in-phase input is connected to the quadrature output and the quadrature input is connected to the in-phase output.

**2.** Receiver device according to claim 1,
**characterized in that**
the device for switching over the in-phase and quadrature terminal comprises a first multiplexer (8), the output of which is connected to the in-phase terminal, and a second multiplexer (9), the output of which is connected to the quadrature terminal of the first and the second input of the step-down controller, respectively.

**3.** Receiver device according to claim 2,
**characterized in that**
the first multiplexer (8) and the second multiplexer (9) respectively comprise a control input for switching between the first and the second switching state, wherein both control inputs are connected to each other for supplying the control signal.

4. Receiver device according to one of claims 1 to 3,
   **characterized in that**
   a frequency generator (17) designed to generate a local oscillator signal is provided, having an output comprising an in-phase and a quadrature terminal, which is coupled to the second input of the step-down controller (1).

5. Receiver device according to one of the claims 1 to 4,
   **characterized in that**
   the receiver is formed as heterodyne receiver, having a further step-down controller (18), the output of which is coupled to the first input of the step-down controller (1).

6. Receiver device according to claim 4,
   **characterized in that**
   the device for switching over the in-phase and the quadrature terminal (8, 9) is interconnected between the output of the frequency generator (17) and the second input of the step-down controller (1).

7. Receiver device according to claim 5,
   **characterized in that**
   the device for switching over the in-phase and quadrature terminal (8, 9) is interconnected between the output of the further step-down controller (18) and the first input of the step-down controller (1).

8. Receiver device according to claim 7,
   **characterized in that**
   a further device for switching over the in-phase and quadrature terminal (15, 16) is coupled to the output of the step-down controller (1).

9. Receiver device according to one of the claims 1 to 8
   **characterized in that**
   a demodulator (14) arranged as quadri-correlator is switched downstream from the step-down controller (1).

**Revendications**

1. Ensemble de réception, notamment pour la radiotéléphonie mobile, comportant

   - un mélangeur (1) de fréquence en aval, conçu pour la multiplication de signaux à valeurs complexes et comprenant une première entrée ayant une borne en phase et une borne en quadrature, une deuxième entrée ayant une borne en phase et une borne en quadrature et une sortie ayant une borne en phase et une borne en quadrature, et
   - un dispositif de commutation de la borne (8, 9) en phase et de la bande en quadrature, en fonction d'un signal de commande, en fonction du point de savoir si le signal utile se trouve dans la bande latérale de réception supérieure ou inférieure, qui a une entrée en phase et une entrée en quadrature, ainsi qu'une sortie en phase et une sortie en quadrature, qui sont raccordées à la borne en phase et à la borne en quadrature de la première ou de la deuxième entrée du mélangeur (1) de fréquence en aval, ayant un premier état de commutation, dans lequel l'entrée en phase est reliée à la sortie en phase et l'entrée en quadrature est reliée à la sortie en quadrature et un deuxième état de commutation, dans lequel l'entrée en phase est reliée à la sortie en quadrature et l'entrée en quadrature est reliée à la sortie en phase.

2. Ensemble de réception suivant la revendication 1,
   **caractérisé en ce que**
   le dispositif de commutation de la borne en phase et de la borne en quadrature comprend un premier multiplexeur (8), dont la sortie est reliée à la borne en phase et un deuxième multiplexeur (9), dont la sortie est reliée à la borne en quadrature de la première ou de la deuxième entrée du mélangeur de fréquence en aval.

3. Ensemble de réception suivant la revendication 2,
   **caractérisé en ce que**

le premier multiplexeur (8) et le deuxième multiplexeur (9) ont chacun une entrée de commande pour la commutation entre le premier et le deuxième état de commutation, les deux entrées de commande étant reliées entre elles pour l'envoi du signal de commande.

4. Ensemble de réception suivant l'une des revendications 1 à 3,
   **caractérisé en ce**
   **qu'**il est prévu un générateur (17) de fréquence constitué pour la production d'un signal d'oscillateur local et comprenant une sortie qui a une borne en phase et une borne en quadrature et qui est couplée à la deuxième entrée du mélangeur (1) de fréquence en aval.

5. Ensemble de réception suivant l'une des revendications 1 à 4,
   **caractérisé en ce que**
   le récepteur est constitué sous la forme d'un récepteur hétérodyne ayant un autre mélangeur (18) de fréquence en aval, qui est couplé par sa sortie à la première entrée du mélangeur (1) de fréquence en aval.

6. Ensemble de réception suivant la revendication 4,
   **caractérisé en ce que**
   le dispositif de commutation des bornes (8, 9) en phase et en quadrature est monté entre la sortie du générateur (17) de fréquence et la deuxième entrée du mélangeur (1) de fréquence en aval.

7. Ensemble de réception suivant la revendication 5,
   **caractérisé en ce que**
   le dispositif de commutation des bornes (8, 9) en phase et en quadrature est monté entre la sortie de l'autre mélangeur (18) de fréquence en aval et de la première entrée du mélangeur (1) de fréquence en aval.

8. Ensemble de réception suivant la revendication 7,
   **caractérisé en ce qu'**un autre dispositif de commutation des bornes (15, 16) en phase et en quadrature est couplé à la sortie du mélangeur (1) de fréquence en aval.

9. Ensemble de réception suivant l'une des revendications 1 à 8,
   **caractérisé en ce qu'**un démodulateur (14) réalisé sous la forme d'un quadricorrélateur est monté en aval du mélangeur (1) de fréquence en aval.

FIG 1

weitere
mögliche
Zwischenverarbeitung

Demodulation

$\sin(\omega_{IF}t)$

$\cos(\omega_{IF}t)$

MUX

MUX

EP 1 516 468 B1

FIG 2

EP 1 516 468 B1

sin(ω$_{IF}$t)

cos(ω$_{IF}$t)

weitere
mögliche
Zwischenverarbeitung

Demodulation

MUX

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 10046586
- DE 19536526 A
- US 5878089 A